# EUROPEAN PATENT APPLICATION

(11) **EP 2 947 768 A1**
(43) Date of publication of application: **25.11.2015**
(21) Application number: 14168767.3
(22) Date of filing: 19.05.2014
(51) Int. Cl.: H03F 1/02

(54) **Load modulation amplification with enhanced load modulation ratio**

(71) Applicant: Nokia Solutions and Networks GmbH & Co. KG, 81541 Munich (DE)
(72) Inventor: Bromberger, Christoph, 74074 Heilbronn (DE)

(57) **Abstract**

There is provided a technique of load modulation amplification with enhanced load modulation ratio. Such technique exemplarily comprise a load modulation amplifier comprising main amplifying means, arranged on a main amplifying path, for amplifying a main portion of an input signal, peak amplifying means, arranged on a peak amplifying path, for amplifying a peak portion of the input signal, splitting means for splitting power of the input signal to the main amplifying path and the peak amplifying path in accordance with a predetermined splitting ratio, and driving means, arranged on the peak amplifying path between the splitting means and the peak amplifying means, for driving the fraction of the input signal power directed to the peak amplifying path in accordance with a predetermined driving factor larger than 1.

## Description

### Field

The present invention relates to load modulation amplification with enhanced load modulation ratio. More specifically, the present invention relates to a load modulation amplifier, such as e.g. a power amplifier of Doherty type, with enhanced load modulation ratio, a method of operating the same, and a computer program product for carrying out the method of operating the same.

### Background

In communication equipment, power amplifiers are used for amplification of radio frequency (RF) signals. For increasing efficiency of signal amplification, a load modulation amplification technique is proposed.

In a load modulation amplifier, such as e.g. a power amplifier of Doherty type, a main portion of an input signal is amplified by a main amplifier, and a peak portion of the input signal is amplified by a peak amplifier. The load impedance experienced by the main amplifier is modified by the peak amplifier.

In a load modulation amplifier, both main and peak amplifiers operate in parallel into a common load, and the voltage drop at the load is given by the load sum current and the load impedance. Given only the main amplifier is operating and contributing a positive current, there is a voltage drop at the load impedance. Turning on the peak amplifier, the peak amplifier is also operating and contributing a further positive current. Thereby, the voltage drop at the load impedance is modified, while the current contributed by the main amplifier is the same as before. Viewed from the main amplifier, the ratio between the load voltage and the current contributed by the main amplifier has changed. That is, the impact of turning on the peak amplifier is the same as if the load impedance had been modified.

Typically, such load modulation amplifiers are utilized for the efficient amplification of signals with a high peak-to-average ratio. In that case, the amplifier is configured such that under high-drive conditions, i.e. for a peak portion of the input signal power, both main and peak amplifiers are operating into loads maximizing their power output capabilities. In contrast thereto, under low-drive conditions, i.e. for a low or average portion of the input signal power, only the main amplifier is operating into a load maximizing its back-off efficiency. Thus, load modulation amplifiers typically combine a high peak power capability with a high efficiency at low or average power levels.

In order to further increase back-off efficiency in load modulation amplifiers, there is a need to increase the load modulation ratio.

The load modulation ratio is mainly governed by the power ratio of the peak amplifier against the main amplifier. The power ratio may be expressed on the basis of the ratio of the power at the (output of the) peak amplifier to the power at the (output of the) main amplifier. Similarly, taking into consideration the amplification factors/gains of the peak and main amplifiers, the power ratio may be expressed on the basis of the ratio of power at the (input of the) peak amplifier to the power at the (input of the) main amplifier.

With conventional load modulation amplifiers, achieving an increased load modulation ratio requires a large splitting ratio at a splitter for splitting power of the input signal to the main amplifier and the peak amplifier. However, a thus required large splitting ratio has two main disadvantages. On the one hand, while splitters with splitting ratios of e.g. +/-3dB and +/-5dB can be easily realized, it is hard to manufacture splitters with splitting ratios of e.g. +/-6dB and +/-8dB. This is essentially because Wilkinson-type splitters or any type of hybrid splitters require a high line impedance ratio, resulting in partly very thin lines, making the splitters hard to manufacture reliably. Couplers with high coupling ratios, on the other side, are also hard to obtain. On the other hand, besides manufacturability, a large splitting ratio is disadvantageous in that, for low drive levels, only the main amplifier is operational, while all input power directed to the peak amplifier is lost. Therefore, a high splitting ratio reduces the gain with low signal powers. Yet, a low gain (at the final stage of an amplifier) adversely influences amplifier efficiency, thwarting the desired increase in back-off efficiency.

Accordingly, there is a demand for enabling/realizing a technique of load modulation amplification with enhanced load modulation ratio, while ensuring sufficient back-off efficiency as well as manufacturability.

### Summary

Various exemplifying embodiments of the present invention aim at addressing at least part of the above issues and/or problems and drawbacks.

Various aspects of exemplifying embodiments of the present invention are set out in the appended claims.

According to an example aspect of the present invention, there is provided a load modulation amplifier, comprising main amplifying means, arranged on a main amplifying path, for amplifying a main portion of an input signal, peak amplifying means, arranged on a peak amplifying path, for amplifying a peak portion of the input signal, splitting means for splitting power of the input signal to the main amplifying path and the peak amplifying path in accordance with a predetermined splitting ratio, and driving means, arranged on the peak amplifying path between the splitting means and the peak amplifying means, for driving the fraction of the input signal power directed to the peak amplifying path in accordance with a predetermined driving factor larger than 1.

According to a variant of the above load modulation amplifier, the predetermined splitting ratio and the predetermined driving factor are set such that the ratio of the power at the peak amplifying means to the power at the main amplifying means is in accordance with a target load modulation ratio of the input signal power.

According to a variant of the above load modulation amplifier, the target load modulation ratio of the input signal power depends on a size ratio of the peak amplifying means to the main amplifying means.

According to a variant of the above load modulation amplifier, the size ratio of the peak amplifying means to the main amplifying means corresponds to a ratio of the number of amplifying transistors in the peak amplifying means to the number of amplifying transistors in the main amplifying means.

According to a variant of any one of the above load modulation amplifiers, the splitting ratio is set such that a larger fraction of the input signal power is directed to the main amplifying path.

According to a variant of any one of the above load modulation amplifiers, the main amplifying means is operable in any one of class A, class B and class AB, and the peak amplifying means is operable in class C, and/or the driving means is operable in class C.

According to a variant of any one of the above load modulation amplifiers, the load modulation amplifier comprises a power amplifier of Doherty type, and/or the load modulation amplifier comprises a radio frequency amplifier for use in communication equipment.

According to an example aspect of the present invention, there is provided a method of operating a load modulation amplifier comprising main amplifying means, arranged on a main amplifying path, for amplifying a main portion of an input signal and peak amplifying means, arranged on a peak amplifying path, for amplifying a peak portion of the input signal, the method comprising splitting, at splitting means, power of the input signal to the main amplifying path and the peak amplifying path in accordance with a predetermined splitting ratio, driving, at driving means arranged on the peak amplifying path between the splitting means and the peak amplifying means, the fraction of the input signal power directed to the peak amplifying path in accordance with a predetermined driving factor larger than 1, amplifying, at the main amplifying means, the main portion of the input signal, and amplifying, at the peak amplifying means, the peak portion of the input signal.

According to an example aspect of the present invention, there is provided a computer program product comprising computer-executable computer program code which, when the computer program code is executed on a computer, is configured to cause the computer to carry out the method according to the above example aspect.

According to a variant of the above computer program product, the computer program product may comprise or may be embodied as a (tangible/non-transitory) computer-readable (storage) medium or the like, on which the computer-executable computer program code is stored, and/or the program is directly loadable into an internal memory of the computer or a processor thereof.

Further developments and/or modifications of the aforementioned example aspects of the present invention are set out in the following.

By way of exemplifying embodiments of the present invention, a technique of load modulation amplification with enhanced load modulation ratio, while ensuring sufficient back-off efficiency as well as manufacturability can be enabled/realized.

### Brief description of the drawings

In the following, the present invention will be described in greater detail by way of non-limiting examples with reference to the accompanying drawings, in which
Figure 1 shows a simplified block diagram of a structure of a load modulation amplifier according to exemplifying embodiments of the present invention,
Figure 2 shows operational values of an example operation in a structure of a conventional load modulation amplifier,
Figure 3 shows operational values of an example operation in a structure of the load modulation amplifier according to exemplifying embodiments of the present invention, and
Figure 4 shows a flowchart of a method of operating a load modulation amplifier according to exemplifying embodiments of the present invention.

### Detailed description

The present invention is described herein with reference to particular non-limiting examples and to what are presently considered to be conceivable embodiments of the present invention. A person skilled in the art will appreciate that the present invention is by no means limited to these examples and embodiments, and may be more broadly applied.

It is to be noted that the following description of the present invention and its embodiments mainly refers to explanations being used as non-limiting examples for exemplifying purposes. As such, the description of exemplifying embodiments given herein specifically refers to terminology which is related thereto. Such terminology is only used in the context of the presented non-limiting examples, and does naturally not limit the present invention in any way. Rather, any other structures, elements, modules, functionalities, etc. may also be utilized as long as complying with what is described herein and/or exemplifying embodiments described herein are applicable to it.

Hereinafter, various exemplifying embodiments and implementations of the present invention and its aspects are described using several variants and/or alternatives. It is generally noted that, according to certain needs and constraints, all of the described variants and/or alternatives may be provided alone or in any conceivable combination (also including combinations of individual features of the various variants and/or alternatives). In this description, the words "comprising" and "including" should be understood as not limiting the described exemplifying embodiments and implementations to consist of only those features that have been mentioned, and such exemplifying embodiments and implementations may also contain features, structures, elements, modules, functionalities etc. that have not been specifically mentioned.

In the drawings, it is noted that lines/arrows interconnecting individual blocks or entities are generally meant to illustrate an operational coupling there-between, which may be a physical and/or logical coupling, which on the one hand is implementation-independent (e.g. wired or wireless) and on the other hand may also comprise an arbitrary number of intermediary functional blocks or entities not shown.

According to exemplifying embodiments of the present invention, in general terms, there is provided a technique of load modulation amplification with enhanced load modulation ratio, while ensuring sufficient back-off efficiency as well as manufacturability.

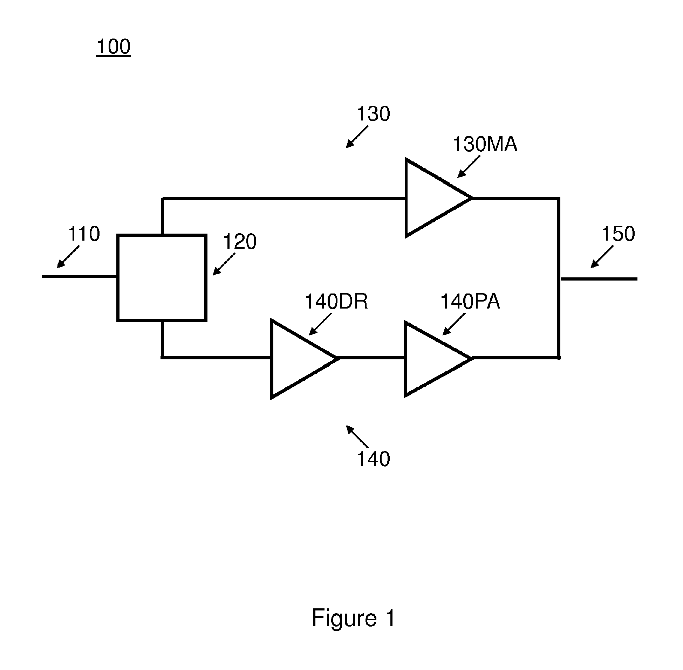

Figure 1 shows a simplified block diagram of a structure of a load modulation amplifier according to exemplifying embodiments of the present invention.

As shown in Figure 1, a load modulation amplifier 100 according to exemplifying embodiments of the present invention comprises an input part/line 110, a splitter 120, a main amplifying path 130, a peak amplifying path 140, and an output part/line 150. The main amplifying path 130 comprises a main amplifier 130MA. The peak amplifying path 140 comprises a peak amplifier 140PA and, arranged between (the output of) the splitter 120 and (the input of) the peak amplifier 140PA, a driver or driver stage 140DR.

As evident from Figure 1, a load modulation amplifier according to exemplifying embodiments of the present invention may comprise a power amplifier of Doherty type. Yet, the present invention is not limited thereto, and may apply, or be applicable for, any type of load modulation amplifier.

The splitter 120 of Figure 1 represents splitting means, and is configured for splitting power of an input signal provided via the input part/line 110 to the main amplifying path 130 and the peak amplifying path 140 in accordance with a predetermined splitting ratio. The splitting ratio of the splitter 120 is such that a fraction of the input signal power is directed to the main amplifying path 130 and another (i.e. the remaining) fraction of the input signal power is directed to the peak amplifying path 140 (when neglecting potential losses or the like). According to exemplifying embodiments of the present invention, the splitting ratio of the splitter 120 may be such that a larger fraction of the input signal power is directed to the main amplifying path 130 (as compared with the fraction of the input signal power directed to the peak amplifying path 140). For example, the splitting ratio of the splitter 120 may be -3dB or -5dB towards the peak amplifying path 140.

The driver or driver stage 140DR of Figure 1 represents driving means, and is configured for driving (i.e. amplifying) the fraction of the input signal power directed from the splitter 120 to the peak amplifying path 140 in accordance with a predetermined driving factor larger than 1 (corresponding to a predetermined driving gain larger than 0dB). For example, the driving gain of the driver or driver stage 140DR may be 10dB. According to exemplifying embodiments of the present invention, the driver or driver stage 140DR may be operable in class C, i.e. may be an amplifier of (or, stated in other words, biased by) class C. Thereby, the power drawn by the driver or driver stage 140DR can be minimized, and back-off efficiency of the load modulation amplifier can be maximized.

The main amplifier 130MA of Figure 1 (which may also be referred to e.g. as first amplifier, carrier amplifier, or the like) represents main amplifying means, and is configured for amplifying a main portion of the input signal provided via the input part/line 110, i.e. the fraction of the input power directed to the main amplifying path 130 by the splitter 120. For example, the main amplifier 130MA may be of (or, stated in other words, biased by) any one of class A, class B or class AB. In this regard, class A refers to an amplifier contributing an output signal for the entire cycle of the input signal, class B refers to an amplifier contributing an output signal for half of the cycle of the input signal, and class AB refers to an amplifier contributing an output signal for at least half of the cycle of the input signal.

The peak amplifier 140PA of Figure 1 (which may also be referred to e.g. as second amplifier, auxiliary amplifier, peaking amplifier, or the like) represents peak amplifying means, and is configured for amplifying a peak portion of the input signal provided via the input part/line 110, i.e. the fraction of the input power directed to the peak amplifying path 140 by the splitter 120, as driven (i.e. amplified) by the driver or driver stage 140DR. For example, the peak amplifier 140PA may be of (or, stated in other words, biased by) class C. In this regard, class C refers to an amplifier contributing an output signal for less than half of the cycle of the input signal.

When the main amplifier 130MA is operated as a class A, B or AB amplifier and the peak amplifier 140PA is operated as a class C amplifier, the peak amplifier is turned off and is effectively an open circuit for low input signals. With higher input signals, the peak amplifier operating point is shifted ('self-biasing'), and the peak amplifier starts to contribute an output signal. At maximum input signals, both main and peak amplifiers are fully operational. Assuming equal amplifier power classes for the main and peak amplifiers, both contribute similar output powers in such fully operational case of maximum input signals. That is to say, the effective load experienced by the main amplifying means is modulated with the help of the peak amplifying means with a load modulation ratio similar/corresponding to the ratio of the maximum output power of the main amplifying means alone as compared to the maximum of the sum of the output powers of the main amplifying means and the peak amplifying means.

In order to further increase back-off efficiency in load modulation amplifiers, a peak-to-main size ratio larger than 1 may be effectively utilized. That is, the number of amplifying transistors in the peak amplifier (e.g. 2) may be higher than the number of amplifying transistors in the main amplifier (e.g. 1), wherein the respective transistors may typically be of the same making, i.e. the same implementation with the same operational parameters. Being operated in class C, the peak amplifier typically offers slightly lower power gain at peak power than the main amplifier being operated in class A, B or AB. Being additionally of a larger size than the main amplifier, the peak amplifier consumes a higher drive power, i.e. requires a higher input power.

According to exemplifying embodiments of the present invention, the predetermined splitting ratio of the splitter 120 and the predetermined driving factor (or gain) of the driver or driver stage 140DR may be set such that the peak-to-main power ratio, i.e. the ratio of power at the (input of the) peak amplifier 140PA to the power at the (input of the) main amplifier 130MA, is in accordance with (i.e. results in or corresponds to) a target load modulation ratio of the input signal power. The predetermined splitting ratio of the splitter 120 and the predetermined driving factor (or gain) of the driver or driver stage 140DR may be set such that the required input power of the peak amplifier 140PA is satisfied, and falls within the output power capability of the driver or driver stage 140DR.

According to exemplifying embodiments of the present invention, the target load modulation ratio of the input signal power may depend on (or, stated in other words, relate to) a peak-to-main size ratio, i.e. a size ratio of the peak amplifier 140PA to the main amplifier 130MA. The peak-to-main size ratio may correspond to a ratio of the number of amplifying transistors in the peak amplifier 140PA to the number of amplifying transistors in the main amplifier 130MA.

According to exemplifying embodiments of the present invention, the splitter 120 may be configurable in terms of (variable) splitting ratio and/or the driver or driver stage 130DR may be configurable in terms of (variable) driving factor (or gain). Accordingly, the splitter 120 and/or the driver or driver stage 130DR may be controlled accordingly, e.g. by a controller, processor, or the like (not illustrated) so as to realize a target load modulation ratio (or, a desired peak-to-main power ratio). Such control may be performed on the basis of the operational parameters of the underlying amplifier to be operated (e.g. output power capabilities of any one of the main amplifying means, the peak amplifying means and the driving means) and/or the peak-to-average ratio of the input signal. To this end, a load modulation amplifier according to exemplifying embodiments of the present invention may further comprise, or be connected/coupled to, detecting means for detecting the peak-to-average ratio of the input signal on the input part/line and control means for controlling at least one of the splitting ratio of the splitting means and the driving factor (or gain) of the driving means on the basis of the detected peak-to-average ratio of the input signal.

It is to be noted that Figure 1 merely shows a simplified block diagram for illustrative purposes, in which only certain elements/modules are represented, and the individual elements/modules are illustrated by a simple block representation. The present invention is however not limited to such exemplary and illustrative structure. For example, any one of the illustrated elements/modules can be implemented by an arbitrary number of constituent parts not illustrated, and/or further elements/modules can be additionally implemented, such that e.g. one or more (e.g. quarter-wavelength) transmission lines, delay lines, phase shifting lines and/or matching networks/circuits, a combiner for combining the amplified signals from the main and peak amplifying paths, a load impedance on the output part/line, or the like may be provided. Also, any one of the main and peak amplifiers may be constructed as a multi-stage amplifier (comprising e.g. at least one internal driver or driver stage), respectively.

Further, it is to be noted that a load modulation amplifier according to exemplifying embodiments of the present invention, as illustrated in Figure 1, is applicable for any purpose and in any technical environment, as long as signal amplification is to be performed. For example, the load modulation amplifier is applicable as a power/RF amplifier for use in any communication equipment, such as e.g. network equipment and/or terminal equipment (in a radio access part) of a wireless communication system, such as GSM, GPRS, UMTS, LTE, LTE-A, or the like.

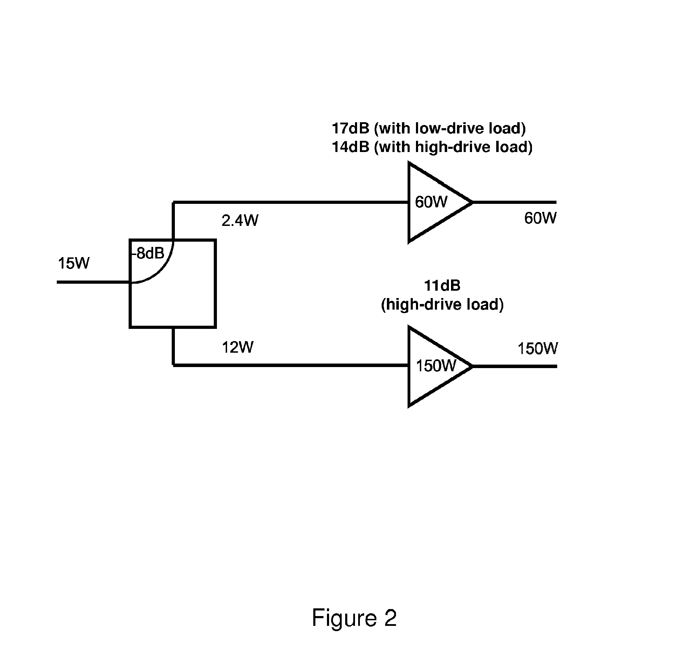

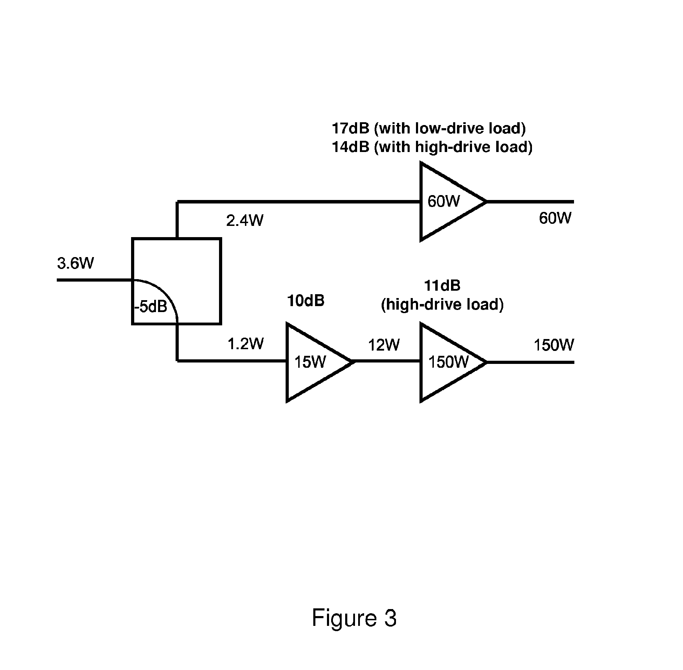

In the following, operational examples of a conventional load modulation amplifier and a load modulation amplifier according to exemplifying embodiments of the present invention are described with reference to Figures 2 and 3.

In Figures 2 and 3, the power numbers at the individual lines represent high-drive power values at the respective points, the power numbers in the individual blocks represent output power capabilities of the respective elements, and decibel numbers in/at the individual blocks represent a transfer ratio/gain of the respective elements.

In the operational examples of Figures 2 and 3, a peak-to-main size ratio of 3 is exemplarily assumed. Further, it is assumed that the main amplifier is operable in class AB, and the peak amplifier is operable in class C. With the main amplifier being operated in class AB and the peak amplifier being operated in class C, an output power ratio of about 150W to 60W between the peak amplifier and the main amplifier is obtained at 1dB of gain compression of a well-designed load modulation amplifier. Accordingly, a target load modulation ratio of about 5dB is exemplarily assumed. The low-drive gain of the main amplifier is assumed to be 17dB. The high-drive gain of the main amplifier - with the effective load of the main amplifier being modulated using the power output of the peak amplifier - is assumed to be 14dB. The high-drive gain of the peak amplifier is assumed to be as low as 11 dB.

Figure 2 shows operational values of an example operation in a structure of a conventional load modulation amplifier.

As shown in Figure 2, a high-drive input signal power of 15W is split, by a splitting ratio of -8dB towards the main amplifying path, resulting in a fraction of 2.4W being directed to the main amplifying path and a fraction of 12W being directed to the peak amplifying path, i.e. a peak-to-main input power ratio of 5. Thereby, the input power need of the peak amplifier, which is assumed to be 12W (due to a correspondingly low high-drive gain of the peak amplifier of 11 dB), is satisfied. The resulting net low-drive gain of this amplifier is 6dB.

As evident, by applying the conventional load modulation amplifier, the target load modulation ratio can be achieved only with a splitting ratio which is in a range of hardly manufacturable splitting ratios, as described above. Accordingly, the thus illustrated amplifier is hardly practicable. Furthermore, an efficient power gain of an amplifier chain including a pre-driver to deliver the necessary power of 15W at a node corresponding to the input part/line 110, as depicted in Fig. 1, is excluded by a low low-drive gain of the thus designed load modulation amplifier of only 6dB.

Figure 3 shows operational values of an example operation in a structure of the load modulation amplifier according to exemplifying embodiments of the present invention.

As shown in Figure 3, a high-drive input signal power of 3.6W is split, by a splitting ratio of -5dB towards the peak amplifying path, resulting in a fraction of 2.4W being directed to the main amplifying path and a fraction of 1.2W being directed to the peak amplifying path. The resulting input signal fraction of 1.2W on the peak amplifying path is driven by a driver stage with a driving gain of 10dB so as to result in 12W at the input of the peak amplifier, i.e. a peak-to-main input power ratio of 5. Thereby, the input power need of the peak amplifier, which is assumed to be 12W (due to a correspondingly low high-drive gain of the peak amplifier of 11 dB), is satisfied. The resulting net low-drive gain of this amplifier is 12dB.

Accordingly, using exemplifying embodiments of the present invention, the effective gain of a load modulation amplifier, such as e.g. a Doherty stage, can be considerably increased without sacrificing efficiency.

As evident, by applying the load modulation amplifier according to exemplifying embodiments of the present invention, the target load modulation ratio can be achieved with a splitting ratio which is in a range of easily manufacturable splitting ratios, as described above. Namely, in the load modulation amplifier according to exemplifying embodiments of the present invention, the target load modulation ratio is realized by the combination of the thus configured splitter and a correspondingly configured driver stage on the peak amplifying path. Accordingly, the thus illustrated amplifier is easily practicable, while ensuring sufficient back-off efficiency. Furthermore, an efficient power gain of an amplifier chain including a pre-driver to deliver the necessary power of 3.6W at a node corresponding to the input part/line 110, as depicted in Fig. 1, can be achieved by a high low-drive gain of the thus designed load modulation amplifier of 12dB.

As mentioned above, the driver or driver stage can be operated in class C. According to such operation, the (direct-current) power drawn by the driver stage can be minimized, and back-off efficiency of the load modulation amplifier can be maximized.

In contrast to a conventional load modulation amplifier, the load modulation amplifier according to exemplifying embodiments of the present invention allows a power splitting with a higher fraction of input power being directed to the main amplifying path, while at the same time satisfying the input power need of the peak amplifier, even with a high peak-to-main size ratio. This is particularly effective for enabling an efficient amplification of input signals with a high peak-to-average ratio.

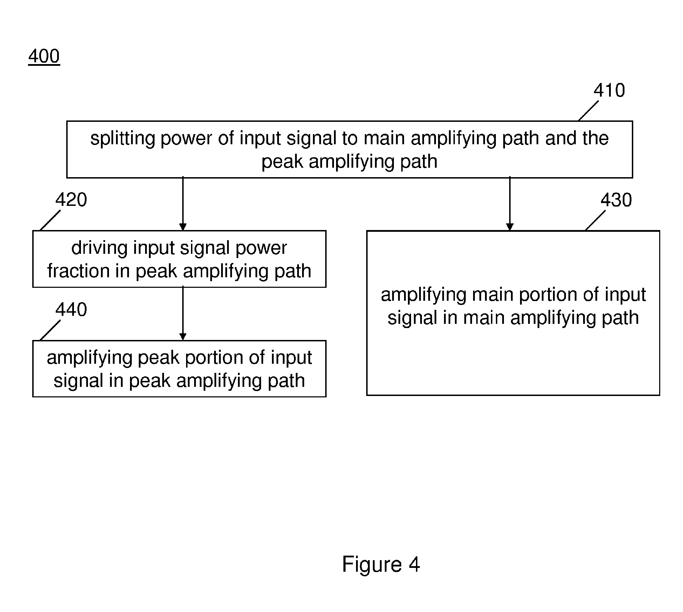

Figure 4 shows a flowchart of a method of operating a load modulation amplifier according to exemplifying embodiments of the present invention.

Such operating method is applicable for any load modulation amplifier comprising main amplifying means, arranged on a main amplifying path, for amplifying a main portion of an input signal and peak amplifying means, arranged on a peak amplifying path, for amplifying a peak portion of the input signal.

Also, such method is usable for designing any such load modulation amplifier, i.e. for designing a load modulation amplifier so as to be operable according to such operating method. Specifically, a load modulation amplifier is to be designed to exhibit the underlying structure and corresponding elements with respective operating functions/capabilities (e.g. including respective operating parameters).

As shown in Figure 4, an operating method 400 of a load modulation amplifier, such as the load modulation amplifier illustrated in Figure 1, according to exemplifying embodiments of the present invention comprises the following processes 410 to 440 as described below. For example, an execution sequence of these processes may be such that process 410 is firstly executed, followed by processes 420, 430 and 440, wherein process 420 is executed prior to process 440, while processes 420 and 440 on the one side and process 430 on the other side are executed independently from each other, e.g. (at least partly) concurrently.

In process 410, power of an input signal is split (at/by splitting means) to the main amplifying path and the peak amplifying path in accordance with a predetermined splitting ratio such that a fraction of the input signal power is directed to the main amplifying path and another (i.e. the remaining) fraction of the input signal power is directed to the peak amplifying path (when neglecting potential losses or the like). In process 420, the fraction of the input signal power directed to the peak amplifying path is driven (i.e. amplified) in accordance with a predetermined driving factor larger than 1 (corresponding to a predetermined driving gain larger than 0dB), at/by driving means arranged on the peak amplifying path between the splitting means and the peak amplifying means. In process 430, the main portion of the input signal is amplified at/by the main amplifying means, wherein the power (of the input signal) at (the input of) the main amplifying means corresponds to the fraction of the input signal power directed to the main amplifying path. In process 440, the peak portion of the input signal is amplified at/by the peak amplifying means, wherein the power (of the input signal) at (the input of) the peak amplifying means corresponds to the fraction of the input signal power directed to the peak amplifying path after being driven by the driving factor.

It is to be noted that Figure 4 merely shows an exemplary flowchart for illustrative purposes, in which an exemplary sequence of processes is illustrated. The present invention is however not limited to the illustrated sequence of processes. Rather, the amplifying process 430 may temporally precede or (at least partly) overlap with the driving process 420, and/or the amplifying process 440 may temporally precede or (at least partly) overlap with the amplifying process 430. Also, additional processes may be comprised in an exemplary operating method of a load modulation amplifier according to exemplifying embodiments of the present invention, such as e.g. an input process of inputting the input signal (e.g. to an input part/line), a process of combining the output signal of the main amplifying means (path) and the peak amplifying means (path), a process of outputting a resulting output signal to an output part/line, and so on.

Further, it is to be noted that the splitting process 410 and/or the driving process 420 may represent control processes for a load modulation amplifier with configurable splitting means and/or configurable driving means, respectively. Namely, the splitting ratio and/or the driving factor (or gain) may be controlled in the splitting process 410 and/or the driving process 420 such that a target load modulation ratio (or, a desired peak-to-main power ratio) is realized. Such control may be performed on the basis of the operational parameters of the underlying amplifier to be operated (e.g. output power capabilities of any one of the main amplifying means, the peak amplifying means and the driving means) and/or the peak-to-average ratio of the input signal.

An operating method according to exemplifying embodiments of the present invention may be implemented by respective functional elements, entities, modules, units, processors, or the like, as described below. For example, it may be implemented by any kind of controller, processor, or the like, by hardware or software (and/or firmware) or any combination thereof. That is, such operating method may be embodied as a computer program product, e.g. computer code instructions stored in a computer-readable memory.

The above-described methods, procedures and functions may be implemented by respective functional elements, entities, modules, units, processors, or the like, as described below.

By virtue of exemplifying embodiments of the present invention, as evident from the above, a technique of load modulation amplification with enhanced load modulation ratio, while ensuring sufficient back-off efficiency as well as manufacturability is enabled/realized.

Accordingly, as compared with conventional load modulation amplification techniques, exemplifying embodiments of the present invention provide for beneficial technical effects in that the load-modulation ratio can be raised and back-off efficiency of power amplifiers can be increased.

It is noted that any power device/transistor at a given frequency has an optimum load impedance for maximum power output and an optimum load impedance for maximum power added efficiency. In LDMOS (Laterally Diffused Metal Oxide Semiconductor) technology, since the two optimum load impedances usually are spaced relative to each other with a relative small distance, a load modulation ratio of 2 may be applied to transform the one into the other impedance. However, in GaN (gallium Nitride) technology, the distance between the two optimum load impedances is usually much larger. Thus, to utilize such power device/transistor at their best, a load modulation ratio of 4, corresponding to a peak-to-main size ratio of 3:1, is needed. In the analog domain, i.e. when using only analog elements, this can be achieved using the teaching of exemplifying embodiments of the present invention, as described herein.

In general, it is to be noted that respective functionalities, functional blocks or elements described above can be implemented by any known means, either in hardware and/or software, respectively, if it is only adapted to perform the described functions of the respective parts. The mentioned method steps can be realized in individual functional blocks or by individual devices, or one or more of the method steps can be realized in a single functional block or by a single device.

Generally, any structural means such as a portion or other circuitry of an amplifier may refer to one or more of the following: (a) hardware-only circuit implementations (such as implementations in only analog and/or digital circuitry) and (b) combinations of circuits and software (and/or firmware), such as (as applicable): (i) a combination of processor(s) or (ii) portions of processor(s)/software (including digital signal processor(s)), software, and memory(ies) that work together to cause an apparatus, such as a mobile phone or server, to perform various functions) and (c) circuits, such as a microprocessor(s) or a portion of a microprocessor(s), that require software or firmware for operation, even if the software or firmware is not physically present. Also, it may also cover an implementation of merely a processor (or multiple processors) or portion of a processor and its (or their) accompanying software and/or firmware, any integrated circuit, or the like.

Generally, any procedural step or functionality is suitable to be implemented as software/firmware or by hardware without changing the idea of the present invention. Such software may be software code independent and can be specified using any known or future developed programming language, such as e.g. Java, C++, C, and Assembler, as long as the functionality defined by the method steps is preserved. Such hardware may be hardware type independent and can be implemented using any known or future developed hardware technology or any hybrids of these, such as MOS (Metal Oxide Semiconductor), CMOS (Complementary MOS), BiMOS (Bipolar MOS), BiCMOS (Bipolar CMOS), ECL (Emitter Coupled Logic), TTL (Transistor-Transistor Logic), etc., using for example ASIC (Application Specific IC (Integrated Circuit)) components, FPGA (Field-programmable Gate Arrays) components, CPLD (Complex Programmable Logic Device) components or DSP (Digital Signal Processor) components. A device/apparatus may be represented by a semiconductor chip, a chipset, or a (hardware) module comprising such chip or chipset; this, however, does not exclude the possibility that a functionality of a device/apparatus or module, instead of being hardware implemented, be implemented as software in a (software) module such as a computer program or a computer program product comprising executable software code portions for execution/being run on a processor. A device may be regarded as a device/apparatus or as an assembly of more than one device/apparatus, whether functionally in cooperation with each other or functionally independently of each other but in a same device housing, for example.

Software in the sense of the present description comprises software code as such comprising code means or portions or a computer program or a computer program product for performing the respective functions, as well as software (or a computer program or a computer program product) embodied on a tangible medium such as a computer-readable (storage) medium having stored thereon a respective data structure or code means/portions or embodied in a signal or in a chip, potentially during processing thereof.

Apparatuses and/or means or parts thereof can be implemented as individual devices, but this does not exclude that they may be implemented in a distributed fashion throughout the system, as long as the functionality of the device is preserved. Such and similar principles are to be considered as known to a skilled person.

The present invention also covers any conceivable combination of method steps and operations described above, and any conceivable combination of nodes, apparatuses, modules or elements described above, as long as the above-described concepts of methodology and structural arrangement are applicable.

In view of the above, there is provided a technique of load modulation amplification with enhanced load modulation ratio. Such technique exemplarily comprise a load modulation amplifier comprising main amplifying means, arranged on a main amplifying path, for amplifying a main portion of an input signal, peak amplifying means, arranged on a peak amplifying path, for amplifying a peak portion of the input signal, splitting means for splitting power of the input signal to the main amplifying path and the peak amplifying path in accordance with a predetermined splitting ratio, and driving means, arranged on the peak amplifying path between the splitting means and the peak amplifying means, for driving the fraction of the input signal power directed to the peak amplifying path in accordance with a predetermined driving factor larger than 1.

Even though the invention is described above with reference to the examples according to the accompanying drawings, it is to be understood that the invention is not restricted thereto. Rather, it is apparent to those skilled in the art that the present invention can be modified in many ways without departing from the scope of the inventive idea as disclosed herein.

## Claims

1. A load modulation amplifier, comprising
main amplifying means, arranged on a main amplifying path, for amplifying a main portion of an input signal,
peak amplifying means, arranged on a peak amplifying path, for amplifying a peak portion of the input signal,
splitting means for splitting power of the input signal to the main amplifying path and the peak amplifying path in accordance with a predetermined splitting ratio, and
driving means, arranged on the peak amplifying path between the splitting means and the peak amplifying means, for driving the fraction of the input signal power directed to the peak amplifying path in accordance with a predetermined driving factor larger than 1.

2. The load modulation amplifier according to claim 1, wherein
the predetermined splitting ratio and the predetermined driving factor are set such that the ratio of the power at the peak amplifying means to the power at the main amplifying means is in accordance with a target load modulation ratio of the input signal power.

3. The load modulation amplifier according to claim 2, wherein
the target load modulation ratio of the input signal power depends on a size ratio of the peak amplifying means to the main amplifying means.

4. The load modulation amplifier according to claim 3, wherein
the size ratio of the peak amplifying means to the main amplifying means corresponds to a ratio of the number of amplifying transistors in the peak amplifying means to the number of amplifying transistors in the main amplifying means.

5. The load modulation amplifier according to any one of claims 1 to 4, wherein the splitting ratio is set such that a larger fraction of the input signal power is directed to the main amplifying path.

6. The load modulation amplifier according to any one of claims 1 to 5, wherein
the main amplifying means is operable in any one of class A, class B and class AB, and the peak amplifying means is operable in class C, and/or
the driving means is operable in class C.

7. The load modulation amplifier according to any one of claims 1 to 6, wherein
the load modulation amplifier comprises a power amplifier of Doherty type, and/or
the load modulation amplifier comprises a radio frequency amplifier for use in communication equipment.

8. A method of operating a load modulation amplifier comprising main amplifying means, arranged on a main amplifying path, for amplifying a main portion of an input signal and peak amplifying means, arranged on a peak amplifying path, for amplifying a peak portion of the input signal, the method comprising
splitting, at splitting means, power of the input signal to the main amplifying path and the peak amplifying path in accordance with a predetermined splitting ratio,
driving, at driving means arranged on the peak amplifying path between the splitting means and the peak amplifying means, the fraction of the input signal power directed to the peak amplifying path in accordance with a predetermined driving factor larger than 1,
amplifying, at the main amplifying means, the main portion of the input signal, and
amplifying, at the peak amplifying means, the peak portion of the input signal.

9. A computer program product comprising computer-executable computer program code which, when the computer program code is executed on a computer, is configured to cause the computer to carry out the method according to claim 8.
